# FASCICULE DE BREVET EUROPEEN

(11) **EP 1 218 757 B1**
(45) Date de publication et mention de la délivrance du brevet: **17.03.2004**
(21) Numéro de dépôt: 01956635.5
(22) Date de dépôt: 24.07.2001
(51) Int. Cl.: G01R 1/073, G01R 3/00

(54) **PROCEDE DE FABRICATION D'UNE CARTE A POINTES DE CONTACT MULTIPLE POUR LE TEST DE CIRCUITS INTEGRES A PLOTS DE CONNEXION EN FORME DE MICROBILLES**
HERSTELLUNGSVERFAHREN FÜR EINE SONDENKARTE MIT MEHREREN KONTAKTPUNKTEN ZUR PRÜFUNG VON INTEGRIERTEN SCHALTUNGEN MIT KUGELMATRIX-VERPACKUNG (BGA)
METHOD FOR MAKING A PROBE CARD WITH MULTIPLE CONTACT TIPS FOR TESTING INTEGRATED CIRCUITS WITH MICROSPHERE CONTACTS

(30) Priorité: 28.07.2000 FR 0009930
(43) Date de publication de la demande: 03.07.2002
(73) Titulaire: Mesatronic, 38500 Voiron (FR)
(72) Inventeur: BELMONT, André, F-38490 La Batie Divisin (FR); ROBERT, Laurent, et 38500 Voiron (FR); AIT MANI, Abdel, Nacer, F-38400 Saint Martin d'Hères (FR)
(74) Mandataire: Hecké, Gérard
(86) Numéro de dépôt international: PCT/FR2001/002411
(87) Numéro de publication internationale: WO 2002/010779

(56) Documents cités:
- EP-A- 0 772 049
- EP-A- 0 999 451
- WO-A-98/45716
- WO-A-98/52218
- KONDOH Y ET AL: "UNIVERSAL MEMBRANE PROBE FOR KNOWN GOOD DIE" INTERNATIONAL JOURNAL OF MICROCIRCUITS AND ELECTRONIC PACKAGING,US,INTERNATIONAL MICROELECTRONICS & PACKAGING SOCIETY, vol. 17, no. 4, 1 octobre 1994 (1994-10-01), pages 323-329, XP000497394 ISSN: 1063-1674

## Description

### Domaine technique de l'invention

L'invention est relative à une carte à pointes multiple destinée notamment à tester des puces semi-conductrices ayant des plots de connexion en forme de microbilles, ladite carte comprenant un substrat constitué par un film flexible isolant équipé de pistes conductrices connectées à des contacts en forme de pointes.

### Etat de la technique

Il est connu de fabriquer des cartes de test à pointes sur des substrats souples en matière isolante, par exemple un film de polyimide, lequel sert à la fois de support aux pistes conductrices, et aux pointes.

Selon les documents US 5412866 et US 4980637, la membrane souple présente une forme convexe, et un matelas en élastomère est agencé à l'arrière de la membrane de manière à obtenir une planéité des extrémités des pointes.

Selon le document US 5914613, les contacts de la carte sont montés sur des poutrelles rigides connectées électriquement à des conducteurs flexibles. Un matelas en élastomère se trouve également à l'arrière de la membrane souple.

Dans le dispositif décrit dans le document EP 259163, un film de polyimide est découpé et conformé selon une tête pyramidale tronquée. Des plaques élastiques en plastique se trouvent entre le film et un support fixe pour contrôler la pression de contact des pointes sur les plots de connexion de la puce à tester.

Le document WO 98/45716 décrit un procédé de fabrication d'une carte de test, dont les pointes sont réalisées par électroformage sur un substrat rigide, par exemple en AsGA, quartz ou verre. Un tel procédé permet d'obtenir dans la zone de contact, une répartition des pointes avec une haute densité et un pas fin.

Le document EP-A2-0999451 décrit un procédé de fabrication complexe d'un appareil de connexion comportant un film multicouches avec une pluralité de terminaux de contact en forme de pointes. Le film multicouches est réalisé en déposant une couche en cuivre de chaque côté d'un élément isolant en polyimide. Une des deux couches en cuivre est gravée à travers un masque pour former un film conducteur et une couche métallique est fixée à l'autre couche en cuivre grâce à une couche adhésive intermédiaire. Une seconde couche adhésive est déposée sur la surface de l'élément isolant comportant le film conducteur et des trous sont formés dans la seconde couche adhésive de manière à recevoir des éléments conducteurs formant des vias destinés à mettre en contact des pointes formant les terminaux de contact avec le film conducteur. Les pointes sont préalablement réalisées par moulage dans une seconde plaquette en silicium puis fixées au film multicouches.

### Objet de l'invention

Un objet de l'invention consiste à réaliser une carte à pointes multiple sur un substrat souple isolant servant à la fois d'amortisseur et de support aux pistes conductrices et aux pointes, et permettant d'obtenir une déformation suffisante pour répartir uniformément la pression de contact des pointes sur les plots de connexion de la puce, avec un effort vertical pur sans frottement.

Selon l'invention, cet objet est atteint par les revendications annexées.

Plus particulièrement, un procédé de fabrication d'une carte à pointes multiple selon l'invention est caractérisé par les étapes suivantes :
- une première couche métallique d'accrochage de faible épaisseur est déposée sur le film flexible isolant,
- une deuxième couche métallique est déposée sous vide ou par électrolyse sur la première couche d'accrochage pour constituer le matériau des futures pistes conductrices,
- on réalise les pointes métalliques sur la seconde couche métallique constitutive des futures pistes conductrices de la carte, par une combinaison d'une première opération de photolithographie UV faisant usage d'une résine photosensible épaisse, et d'un électroformage au moyen d'un électrolyte à ions métalliques,
- on effectue une gravure sélective de la deuxième couche métallique et de la première couche d'accrochage à l'aide d'une deuxième opération de photolithographie UV pour obtenir les pistes conductrices,
- et on dépose une couche isolante superficielle de passivation sur la zone active conductrice.

Le film flexible du substrat est un polymère, notamment un polyimide, ayant une épaisseur supérieure à 25 microns. Une telle épaisseur permet d'obtenir la déformation souhaitée, et de supporter une forte densité de pointes. La première couche métallique d'accrochage est à base de chrome ou de nickel, tandis que la deuxième couche métallique peut être en cuivre, en or, ou en aluminium.

Selon une caractéristique de l'invention, le film souple est monté sur une partie tronquée d'une pièce de maintien coopérant avec un guide associé à une suspension à ressort, de manière à obtenir une répartition uniforme de la pression de contact des pointes sur la totalité des plots de connexion sans frottement latéral. Les pointes obtenues par électroformage peuvent présenter des surfaces de contact planes, concaves ou convexes. La correction du défaut de parallélisme entre le plan du circuit imprimé support et le plan des pointes est opérée au moyen d'un système correcteur à trois points d'appui réglables par vis agissant sur l'embase de la pièce de maintien.

Selon un mode de réalisation préférentiel, la pièce de maintien comprend une partie intermédiaire cylindrique agencée coaxialement à l'intérieur du guide, et ayant un diamètre inférieur à celui de l'embase. La partie tronquée de la pièce de maintien est dotée d'une fenêtre munie d'une plaquette en matériau transparent, en verre ou en quartz, autorisant un test visuel de l'alignement des pointes sur les plots de connexion de la puce semi-conductrice.

### Description des figures

D'autres avantages et caractéristiques ressortiront plus clairement de la description qui va suivre d'un mode de réalisation de l'invention donné à titre d'exemple non limitatif, et représenté aux dessins annexés, dans lesquels:
- la figure 1 montre les différentes étapes a-f du procédé de fabrication de la carte à pointes sur substrat flexible selon l'invention ;
- les figures 2A, 2B, 2C représentent différentes formes de surfaces des pointes de la carte selon l'invention ;

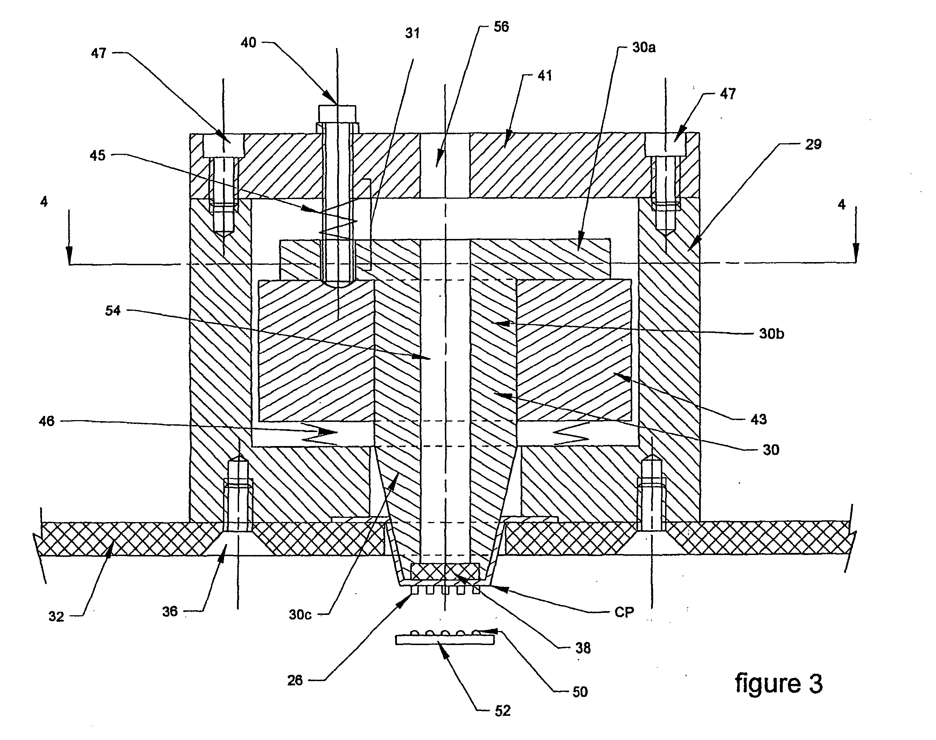

- la figure 3 est une vue en coupe transversale de l'assemblage de test complet ;

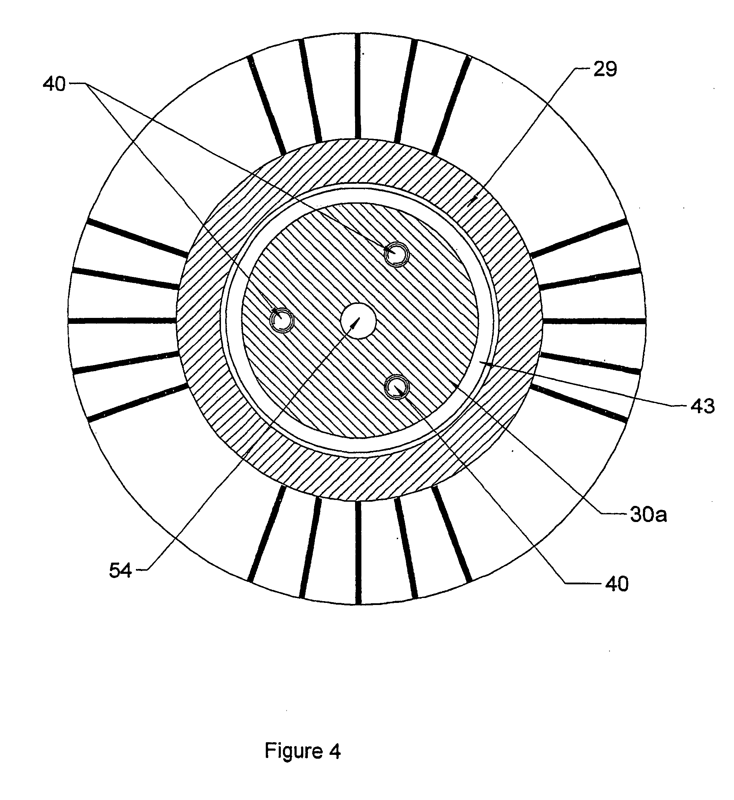

- la figure 4 est une vue en coupe longitudinale selon la ligne 4-4 de la figure 3 au niveau de la fonction de réglage ;
- la figure 5 représente une vue en plan de la carte illustrée à l'étape f de la figure 1 ;

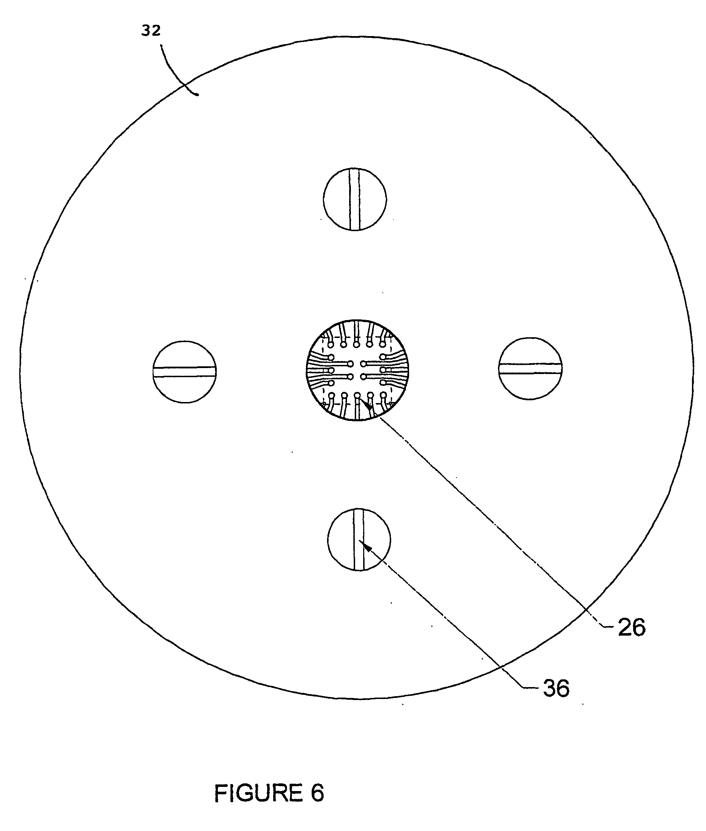

- la figure 6 est une vue de dessous de la figure 3.

### Description d'un mode de réalisation préférentiel

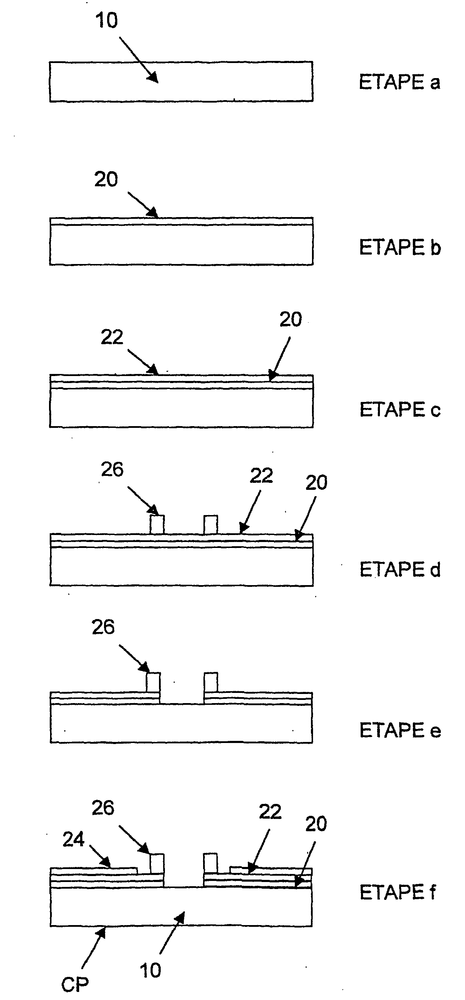

La figure 1 illustre les étapes technologiques mises en oeuvre pour fabriquer la carte à pointes CP sur un substrat souple déformable.

Etape a : on utilise comme substrat 10 un film souple en matière isolante, par exemple de polyimide, ayant une épaisseur de l'ordre de 25 microns.

Etape b : une première couche métallique 20 d'accrochage, notamment à base de chrome ou de nickel, est déposée sur toute la surface du substrat 10 isolant. Le dépôt de la couche 20 s'effectue par évaporation sous vide ou par pulvérisation cathodique. Dans l'exemple illustré à la figure 1, la face de travail est la face supérieure, mais on peut concevoir de travailler sur les deux faces.

Etape c : une deuxième couche métallique 22, constitutive des futures pistes conductrices de la carte, est ensuite déposée sur la couche 20 d'accrochage. La deuxième couche 22 peut être en cuivre, en or ou en aluminium, et est déposée soit en couche mince sous vide, ou soit plus épaisse, par électrolyse par exemple.

Etape d : on réalise une première opération de photolithographie UV après avoir déposé sur la deuxième couche métallique 22 une épaisse couche de résine photosensible, laquelle est révélée après avoir été insolée au travers d'un masque comportant le dessin des pointes. L'opération de photolithographie est suivie par une opération d'électroformage consistant à fabriquer les pointes 26 sous la forme de plots métalliques par l'utilisation d'un électrolyte.

Etape e : une deuxième opération de photolithographie UV permet de graver la deuxième couche métallique 22 et la première couche d'accrochage 20 suivant le tracé des pistes voulu et la forme des pointes 26 réalisées.

Il est clair que l'ordre de succession des étapes d et e peut être inversé.

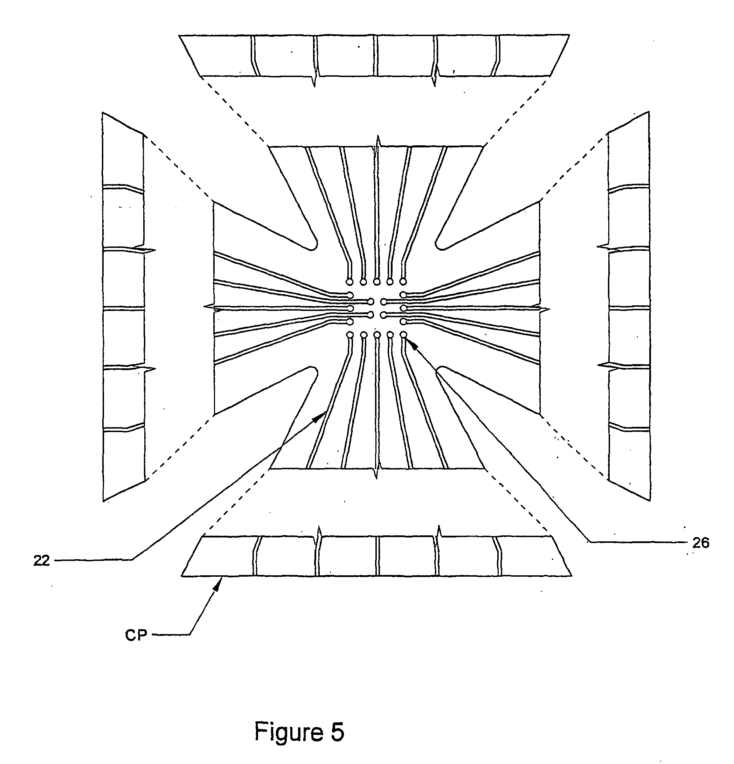

Etape f : on dépose une couche isolante 24 de passivation sur la zone active conductrice. La couche 24 est composée d'un oxyde ou d'un polymère en couche mince déposée localement, et sert à protéger les pistes conductrices, en réduisant les problèmes liés à l'encrassement des pointes lors du test. La figure 5 montre la vue en plan de la carte CP en fin de fabrication.

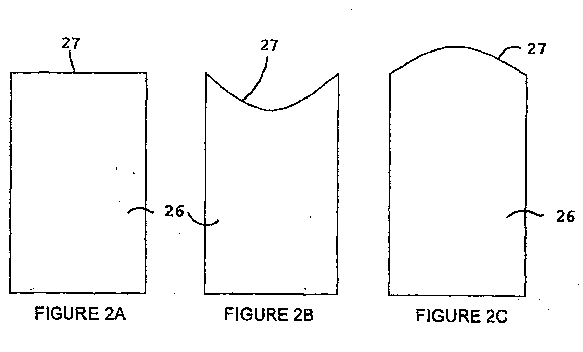

En référence aux figures 2A, 2B, 2C, la surface supérieure 27 des pointes 26 électrodéposées, venant au contact des microbilles à tester, peuvent avoir différentes formes afin de ne pas endommager les microbilles. Sur la figure 2A, la surface supérieure 27 est plane. Sur la figure 2B, la surface supérieure 27 est concave pour épouser la forme complémentaire de la microbille. Sur la figure 2C, la surface supérieure 27 est bombée selon un profil convexe.

Sur les figures ,3, 4 et 6, le substrat 10 souple est monté sur un dispositif support 29, lequel est équipé d'un système correcteur 31 de défaut de parallélisme utilisant des moyens d'appui réglables en trois points.

Le substrat 10 souple est fixé sur une pièce de maintien 30 centrale destinée à se déplacer coaxialement dans un guide 43. La pièce de maintien 30 comporte une embase 30a, une partie intermédiaire 30b cylindrique agencée coaxialement à l'intérieur du guide 29 annulaire, et une partie tronquée 30c sur laquelle est adaptée le substrat 10 flexible. Le contact électrique entre les pistes conductrices de la carte 10 et le circuit imprimé 32 est assuré par appui au moyen de vis 36 d'assemblage vissées dans le support 29. Le mouvement relatif de la pièce 30 mobile dans le guide 43 s'opère en translation verticale ou en rotation autour de l'axe vertical .

Le défaut de parallélisme entre le plan des pointes 26 et le circuit imprimé 32 est corrigé par le système correcteur 31 au moyen de trois vis 40 de réglage décalées angulairement à 120 degrés. Les vis 40 traversent le couvercle 41, et des premiers ressorts 45 sont intercalés entre la face inférieure du couvercle 41 et l'embase 30a circulaire, laquelle prend appui sur la face supérieure du guide 43. Un deuxième ressort 46 est agencé dans l'intervalle opposé ménagé entre la face inférieure du guide 43 et le dispositif support 29. Le couvercle 41 est monté sur le support 29 par des vis 47, et l'embase 30a présente un diamètre supérieur à celui de partie intermédiaire 30b de la pièce 30.

L'alignement des pointes 26 sur les plots de connexion 50 de la puce 52 semi-conductrice à tester, est visuel et s'effectue au moyen d'une fenêtre 38 dotée d'une plaquette en matériau transparent, en verre ou en quartz, laquelle est disposée en regard d'ouvertures 54, 56 alignées coaxialement dans la pièce tronquée 30 et le couvercle 41.

Le contact des pointes 26 avec les plots de connexion 50 de la puce 52 s'opère sans frottement latéral notable de manière à éviter l'usure des plots. La flexibilité du film souple du substrat 10 sert d'une part d'amortisseur absorbant les efforts de compression pendant l'opération de test, et d'autre part de répartiteur de la pression de contact sur la totalité des plots de connexion 50 sphériques de la puce 52.

## Revendications

1. Procédé de fabrication d'une carte à pointes multiple destinée notamment à tester des puces semi-conductrices ayant des plots de connexion en forme de microbilles, ladite carte comprenant un substrat (10) constitué par un film flexible isolant équipé de pistes conductrices connectées à des contacts en forme de pointes (26), ledit procédé étant **caractérisé par** les étapes suivantes :
- une première couche métallique (20) d'accrochage de faible épaisseur est déposée sur le film flexible isolant,
- une deuxième couche métallique (22) est déposée sous vide ou par électrolyse sur la première couche (20) d'accrochage pour constituer le matériau des futures pistes conductrices,
- on réalise les pointes (26) métalliques sur la seconde couche métallique (22) constitutive des futures pistes conductrices de la carte, par une combinaison d'une première opération de photolithographie UV faisant usage d'une résine photosensible épaisse, et d'un électroformage au moyen d'un électrolyte à ions métalliques,
- on effectue une gravure sélective de la deuxième couche métallique (22) et de la première couche (20) d'accrochage à l'aide d'une deuxième opération de photolithographie UV pour obtenir les pistes conductrices,
- et on dépose une couche isolante (24) superficielle de passivation sur la zone active conductrice.

2. Procédé de fabrication d'une carte à pointes selon la revendication 1, **caractérisé en ce que** le film flexible du substrat (10) est un polymère, notamment un polyimide, ayant une épaisseur supérieure à 25 microns.

3. Procédé de fabrication d'une carte à pointes selon la revendication 1, **caractérisé en ce que** la première couche métallique (20) d'accrochage est à base de chrome ou de nickel.

4. Procédé de fabrication d'une carte à pointes selon la revendication 1, **caractérisé en ce que** la deuxième couche métallique (22) peut être en cuivre, en or, ou en aluminium.

5. Procédé de fabrication d'une carte à pointes selon la revendication 1, **caractérisé en ce que** les pointes (26) obtenues par électroformage présentent des surfaces de contact planes, concaves ou convexes.

## Claims

1. A process for manufacturing a card with multiple tips designed in particular for testing semi-conductor chips having connection pads in the form of microspheres, said card comprising a substrate (10) formed by a flexible insulating film equipped with conducting tracks connected to contacts in the form of tips (26), said process being **characterized by** the following stages:
- a first adhesive metal layer (20) of small thickness is deposited on the flexible insulating film,
- a second metal layer (22) is deposited by vacuum or electrolysis on the first adhesive layer (20) to form the material of the future conducting tracks,
- the metal tips (26) are achieved on the second metal layer (22) constitutive of the future conducting tracks of the card, by a combination of a first UV photolithography operation making use of a thick photosensitive resin and electroforming by means of a metal-ion electrolyte,
- selective etching of the second metal layer (22) and of the first adhesive layer (20) is performed by means of a second UV photolithography operation to obtain the conducting tracks,
- and a superficial passivation insulating layer (24) is deposited on the active conducting area.

2. The process for manufacturing a card with tips according to claim 1, **characterized in that** the flexible film of the substrate (10) is a polymer, in particular a polyimide, having a thickness greater than 25 microns.

3. The process for manufacturing a card with tips according to claim 1, **characterized in that** the first adhesive metal layer (20) is chrome- or nickel-based.

4. The process for manufacturing a card with tips according to claim 1, **characterized in that** the second metal layer (22) can be made of copper, gold or aluminium.

5. The process for manufacturing a card with tips according to claim 1, **characterized in that** the tips (26) obtained by electroforming present flat, concave or convex contact surfaces.

## Patentansprüche

1. Verfahren zur Herstellung einer Sondenkarte, die insbesondere zur Prüfung integrierter Schaltungen mit Verbindungsstellen in Form kleiner Kugeln bestimmt ist, wobei die Karte ein Substrat (10) umfasst, das von einer weichelastischen Isolierfolie gebildet wird, die mit Leiterbahnen mit höckerförmigen Kontakten (26) versehen ist, welches Verfahren durch folgende Schritte gekennzeichnet ist:
- Aufbringen einer ersten metallenen Befestigungsschicht (20) geringer Dicke auf die weichelastische Isolierfolie,
- Aufbringen einer zweiten Metallschicht (22) unter Vakuum oder durch Elektrolyse auf die erste Befestigungsschicht (20), um das Material der späteren Leiterbahnen zu bilden,
- Herstellen metallener Kontaktstellen (26) auf der zweiten Metallschicht (22), welche die späteren Leiterbahnen bilden wird, und zwar mittels einer Kombination aus einem ersten UV-Fotolithografieschritt, bei dem ein dickes fotosensibles Harz eingesetzt wird, und einem Elektroformungsvorgang mittels eines Elektrolyts mit Metallionen,
- selektives Ätzen der zweiten Metallschicht (22) und der ersten Befestigungsschicht (20) durch einen zweiten UV-Fotolithografieschritt zum Erhalt der Leiterbahnen,
- und Aufbringen einer oberflächlichen Passivierungs-lsolierschicht (24) auf den aktiven leitenden Bereich.

2. Herstellungsverfahren für eine Sondenkarte nach Anspruch 1, **dadurch gekennzeichnet, dass** die weichelastische Folie des Substrats (10) ein Polymer, insbesondere ein Polyimid, mit einer Dicke von über 25 Micron ist.

3. Herstellungsverfahren für eine Sondenkarte nach Anspruch 1, **dadurch gekennzeichnet, dass** die erste Befestigungs-Metallschicht (20) eine Schicht auf Basis von Chrom oder Nickel ist.

4. Herstellungsverfahren für eine Sondenkarte nach Anspruch 1, **dadurch gekennzeichnet, dass** die zweite Metallschicht (22) aus Kupfer, Gold oder Aluminium bestehen kann.

5. Herstellungsverfahren für eine Sondenkarte nach Anspruch 1, **dadurch gekennzeichnet, dass** die durch Elektroformen erhaltenen Kontaktstellen (26) ebene, konkave oder konvexe Kontaktflächen aufweisen.
